# EUROPEAN PATENT APPLICATION

(11) **EP 2 813 597 A1**
(43) Date of publication of application: **17.12.2014**
(21) Application number: 12868093.1
(22) Date of filing: 11.09.2012
(51) Int. Cl.: C23C 14/24, H01L 51/50, H05B 33/10

(54) **CRUCIBLE FOR VAPOR DEPOSITION, VAPOR DEPOSITION DEVICE, AND VAPOR DEPOSITION METHOD**

(30) Priority: 10.02.2012 JP 2012027451
(71) Applicant: Nitto Denko Corporation, Ibaraki-shi, Osaka 567-8680 (JP)
(72) Inventor: KAKIUCHI, Ryohei, Ibaraki-shi Osaka 567-8680 (JP); YAMAMOTO, Satoru, Ibaraki-shi Osaka 567-8680 (JP)
(74) Representative: Stolmár & Partner
(86) International application number: PCT/JP2012/073113
(87) International publication number: WO 2013/118341

(57) **Abstract**

Provided are a crucible for vapor deposition, a vapor deposition apparatus and a vapor deposition method capable of detecting a film formation rate using a sensor in vapor deposition by proximity vapor deposition. The crucible according to the present invention includes a storage section that stores a vapor deposition source, a first guide passage that guides a vaporized material emitted from the vapor deposition source toward a substrate to be treated, a wall section for defining the first guide passage and a second guide passage that diverges from a middle part of the first guide passage, penetrates the wall section and communicates with the outside.

## Description

### CROSS-REFERENCE TO RELATED APPLICATIONS

The present application claims priority based on Japanese Patent Application No. 2012-027451, the disclosure of which is incorporated herein by reference in its entirety.

### FIELD OF THE INVENTION

The present invention relates to a crucible for vapor deposition, a vapor deposition apparatus and a vapor deposition method that allow a vaporized material vaporized from a vapor deposition source to be vapor-deposited on a substrate to be treated.

### RELATED ART

Regarding conventional vapor deposition apparatuses, for example, a substrate to be treated is disposed in a vacuum chamber and a vapor deposition source is disposed at a predetermined distance from this substrate to be treated. Such vapor deposition apparatuses generally emit the vaporized material vaporized from the vapor deposition source toward the substrate to be treated to thereby form a thin film of a predetermined film thickness (e.g., see Patent Literature 1).

More specifically, this vapor deposition apparatus includes in its vacuum chamber, a crucible that stores a vapor deposition source and a heat generator to heat this crucible. The vapor deposition apparatus heats the crucible through radiant heat and/or heat conduction from the heat generator and thereby emits the vaporized material from the vapor deposition source. The vapor deposition apparatus causes the vaporized material to be vapor-deposited on the substrate to be treated, and thereby forms a film.

As shown above, in the conventional vapor deposition apparatus, the vapor deposition source and the substrate to be treated are spaced apart from each other, but this spacing is preferably minimized to the extent possible from the standpoint of downsizing of the apparatus and effective utilization of the vapor deposition source.

### CITATION LIST

### Patent Literature

Patent Literature 1: JP 2008-163365 A

### DISCLOSURE OF THE INVENTION

### PROBLEMS TO BE SOLVED BY THE INVENTION

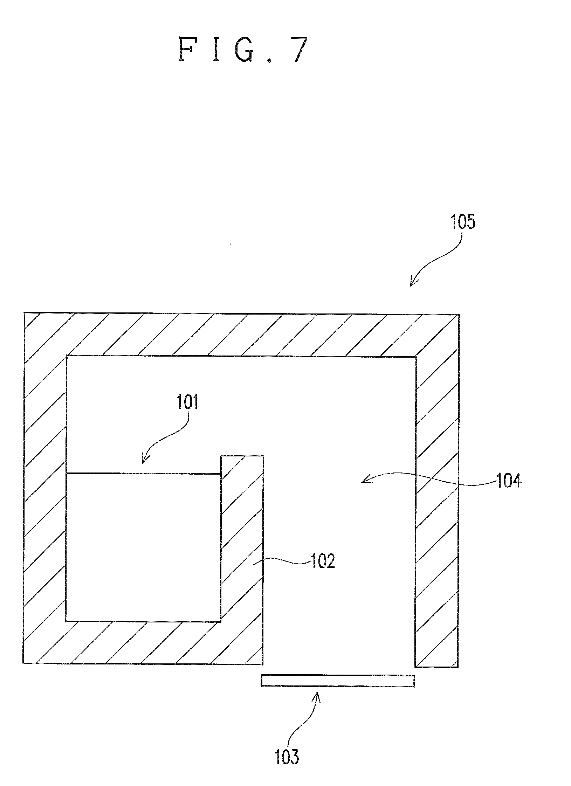

From this standpoint, a technique under research and development in recent years is called "proximity vapor deposition." As shown, for example, in FIG. 7, this proximity vapor deposition uses a crucible 105 which includes a storage section 102 that stores a vapor deposition source 101 and a guide passage 104 that guides a vaporized material from the vapor deposition source 101 to a substrate to be treated 103. In the proximity vapor deposition, since the guide passage 104 is formed in the crucible 105, it is possible to minimize the distance between the vapor deposition source 101 and the substrate to be treated 103.

Incidentally, in vapor deposition by the vapor deposition apparatus, it is necessary to check the conditions of the vapor deposition (so-called film formation rate). For this reason, a sensor for measuring the thickness of the film formed on the substrate to be treated is conventionally provided in the vacuum chamber. For example, QCM (Quartz Crystal Microbalance) is used as this sensor. This QCM can detect a film formation rate based on a frequency variation in accordance with the amount of deposition of the vaporized material adhered to a crystal resonator disposed at a predetermined position in the vacuum chamber.

When the above-described sensor is also used for proximity vapor deposition, even when the sensor is placed in the vacuum chamber, the vaporized material does not stick out of the guide passage 104 in the crucible 105. For this reason, the vaporized material does not reach this sensor. Therefore, the sensor cannot detect the film formation rate.

On the other hand, this sensor may be placed in the guide passage 104. In this case, since the vaporized material and the crucible itself in the guide passage 104 are hot, there is a problem that the measuring accuracy of the sensor under influences of high temperature may deteriorate extremely.

The present invention has been implemented in view of the above-described circumstances, and it is an object of the present invention to provide a crucible for vapor deposition, a vapor deposition apparatus and a vapor deposition method capable of detecting a film formation rate using a sensor in vapor deposition through proximity vapor deposition.

### MEANS FOR SOLVING PROBLEMS

A crucible for vapor deposition according to the present invention is intended to solve the above-described problems and includes a storage section that stores a vapor deposition source, a first guide passage that guides a vaporized material emitted from the vapor deposition source toward a substrate to be treated, a wall section for defining the first guide passage, and a second guide passage that diverges from a middle part of the first guide passage, penetrates the wall section and communicates with the outside.

Furthermore, the present invention can adopt a configuration in which a protrusion that protrudes outward is provided on an outside surface of the wall section and the second guide passage is formed so as to penetrate the protrusion and communicate with an orifice of the wall section.

According to another aspect of the present invention, there is provided a vapor deposition apparatus, which includes any one of the above-described crucibles for vapor deposition, a vacuum chamber that can store the crucible for vapor deposition therein, a vacuum pump connected to the vacuum chamber, a heater for heating the crucible for vapor deposition, and a sensor for measuring the thickness of a film formed by the vaporized material adhering to a substrate to be treated.

Furthermore, according to still another aspect of the the present invention, there is provided a vapor deposition method for causing a vaporized material emitted from a vapor deposition source to be vapor-deposited on a substrate to be treated by the above-described vapor deposition apparatus, the method including detecting the vaporized material emitted from the second guide passage by the sensor provided in the vacuum chamber, and causing the vaporized material to be vapor-deposited on the substrate to be treated while measuring the thickness of the film formed by the vaporized material adhering to the substrate to be treated.

### BRIEF DESCRIPTION OF THE DRAWINGS

FIG. 1 is a cross-sectional view of a vapor deposition apparatus illustrating a first embodiment of the present invention.
FIG. 2 is a cross-sectional view of a vapor deposition apparatus illustrating a second embodiment of the present invention.
FIG. 3 is a cross-sectional view of a vapor deposition apparatus illustrating a third embodiment of the present invention.
FIG. 4 is a cross-sectional view of a vapor deposition apparatus illustrating a fourth embodiment of the present invention.
FIG. 5 is a cross-sectional view of a vapor deposition apparatus illustrating a fifth embodiment of the present invention.
FIG. 6 is a cross-sectional view of a vapor deposition apparatus illustrating a sixth embodiment of the present invention.
FIG. 7 is a cross-sectional view of a crucible illustrating an example of proximity vapor deposition.

### DESCRIPTION OF EMBODIMENTS

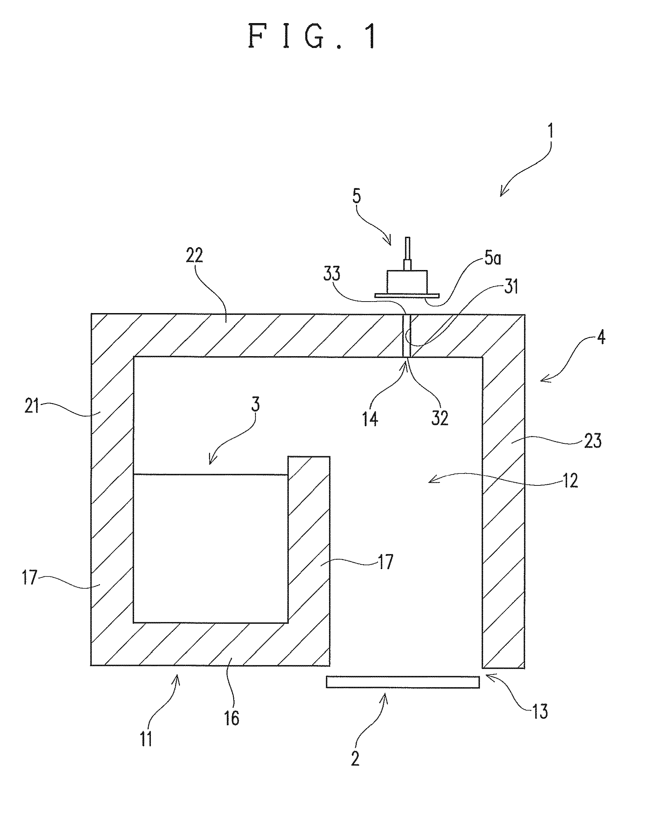

Hereinafter, embodiments of the present invention will be described with reference to FIG. 1 to FIG. 6. FIG. 1 illustrates a first embodiment of the present invention. A vapor deposition apparatus 1 according to the present embodiment is used to manufacture, for example, an organic EL device or other devices through so-called proximity vapor deposition. The vapor deposition apparatus 1 forms a thin film of a predetermined thickness by causing a vaporized material vaporized from a vapor deposition source 3 to be vapor-deposited on a predetermined substrate to be treated 2. More specifically, this vapor deposition apparatus 1 is provided with a vacuum chamber (not shown), a vacuum pump (not shown) connected to the vacuum chamber, a vapor deposition source 3, a crucible for vapor deposition (hereinafter simply referred to as "crucible") 4 stored in the vacuum chamber, a sensor 5 provided at a position proximate to the crucible 4 to measure a thickness of a thin film formed on the substrate to be treated 2, and a heater (not shown) that heats the crucible 4.

Hereinafter, a positional relationship between the crucible 4 and the sensor 5 will be particularly described. As shown in FIG. 1, the crucible 4 includes a storage section 11 that stores a vapor deposition source 3, a first guide passage 12 that guides a vaporized material emitted from the vapor deposition source 3 to the substrate to be treated 2, an emission port 13 provided at one end of the first guide passage 12 to emit the vaporized material, which passes through this first guide passage 12, toward the substrate to be treated 2 disposed in proximity to the vapor deposition source 3, and a second guide passage 14 that diverges from a middle part of the first guide passage 12 and communicates with the outside of the crucible 4.

To store the vapor deposition source 3, the storage section 11 includes a bottom wall section 16 and a side wall section 17 provided perpendicular to this bottom wall section 16. A storage space for the vaporized material is formed by the storage section 11 being surrounded by these wall sections. When heated by a heater from the outside, the storage section 11 is configured to transmit the heat to the vapor deposition source 3.

The first guide passage 12 is formed of a wall section provided so as to cover the storage section 11. This wall section includes a first wall section 21 formed integrally and continuously connected with part of the side wall section 17 of the storage section 11, a second wall section 22 that extends so as to be substantially orthogonal to the first wall section 21, and a third wall section 23 provided so as to be substantially orthogonal to the second wall section 22 and substantially parallel to the first wall section 21. Note that the first wall section 21 and the third wall section 23 are connected via a fourth wall section and a fifth wall section having similar configurations, but description thereof is not repeated in the present embodiment. The first guide passage 12 is formed in a space defined by and covered with the first wall section 21 to the fifth wall section described above.

According to the above-described configuration, the first guide passage 12 guides the vaporized material emitted from the vapor deposition source 3 upward via the first wall section 21 and also guides the vaporized material in a lateral direction via the second wall section 22. Furthermore, the first guide passage 12 guides the vaporized material downward via the third wall section 23. The first guide passage 12 causes the vaporized material to be emitted toward the substrate to be treated 2 via the emission port 13. The vaporized material emitted from the emission port 13 is deposited on the substrate to be treated 2. A film is thus formed on the surface of the substrate to be treated 2.

The second guide passage 14 is provided at a middle part of the second wall section 22. More specifically, the second guide passage 14 is configured of an orifice 31 that penetrates the second wall section 22 and communicates with the outside. An opening of the orifice 31 on an inner surface side of the second wall section 22 constitutes an inlet 32 for the vaporized material. An opening of the orifice 31 on an outer surface side of the second wall section 22 constitutes an outlet 33 for the vaporized material. The diameter or width of this orifice 31 is constant from the inlet 32 to the outlet 33. The diameter or width of this orifice 31 is preferably smaller than that of the first guide passage 12. For example, the diameter or width of this orifice 31 is preferably in the order of 1 mm to 3 mm. However, without being limited to this, the diameter or width of this orifice 31 may also be smaller or greater than the above-described value.

In the present embodiment, a crystal resonator (QCM) is used for the sensor 5. This sensor 5 is provided at a position proximate to the crucible 4 in the vacuum chamber. More specifically, the sensor 5 is disposed above the second guide passage 14 formed in the second wall section 22 of the crucible 4. Moreover, a detection surface 5a of the sensor 5 is disposed so as to face the outlet 33 of the second guide passage 14.

According to the vapor deposition apparatus 1 having the above-described configuration and a vapor deposition method using this vapor deposition apparatus 1, the first guide passage 12 formed in the crucible 4 guides the vaporized material to the substrate to be treated 2, the second guide passage 14 that diverges from the first guide passage 12 guides the vaporized material to the sensor 5 provided outside the crucible 4, and it is thereby possible to form a predetermined film on the substrate to be treated 2 and at the same time detect the film formation rate (vapor deposition rate) thereof using the sensor 5.

This second guide passage 14 is formed by simply forming the orifice 31 that penetrates the second wall section 22, and can thus be manufactured easily due to its simplified structure.

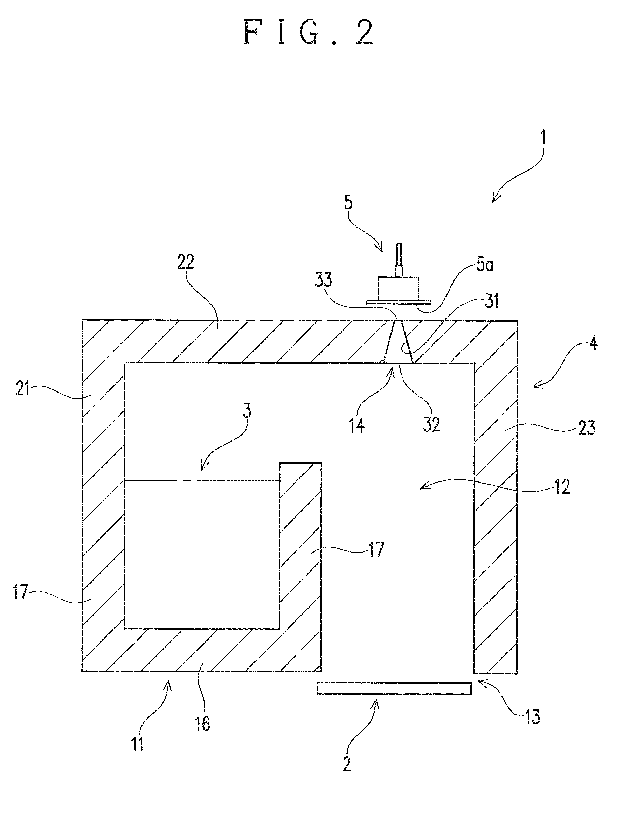

FIG. 2 illustrates a second embodiment of the vapor deposition apparatus 1, the crucible 4 and the vapor deposition method according to the present invention. In the present embodiment, the shape of the orifice 31 as the second guide passage 14 is different from that of the first embodiment. More specifically, in the second guide passage 14 of the aforementioned first embodiment, the orifice 31 is formed such that the diameter or width thereof is constant from the inlet 32 to the outlet 33, whereas in the present embodiment, the diameter of the inlet 32 is greater than the diameter of the outlet 33. This allows more vaporized material to be introduced from the inlet 32 of the second guide passage 14 and allows the vaporized material having a higher density to be emitted toward the sensor 5 from the outlet 33 which is formed to be smaller than the inlet 32.

The other aspects of the present embodiment are the same as those of the first embodiment, and operations and effects similar to those of the first embodiment are exerted in the present embodiment as well.

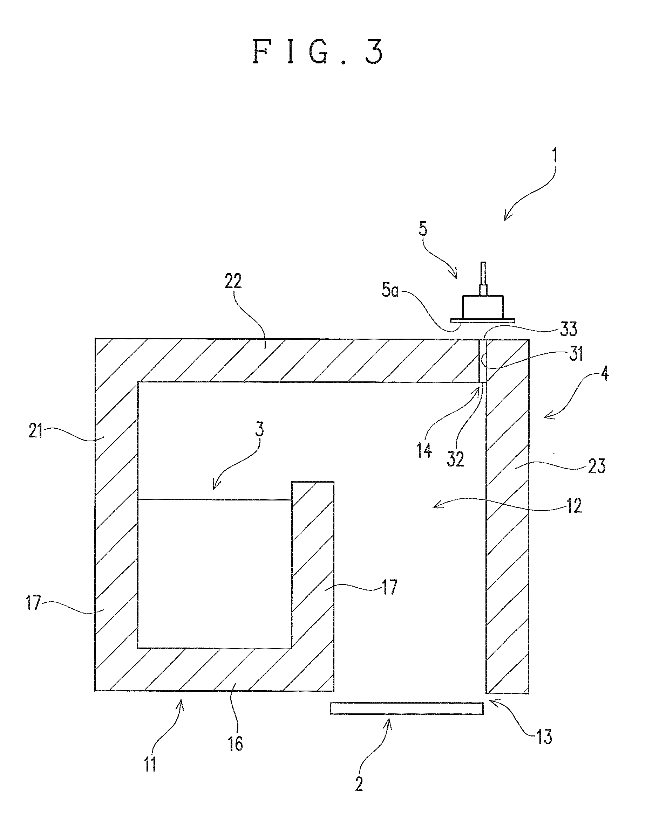

FIG. 3 illustrates the vapor deposition apparatus 1, the crucible 4 and the vapor deposition method according to a third embodiment of the present invention. In the present embodiment, the position of the orifice 31 as the second guide passage 14 is different from that of the first embodiment. More specifically, in the first embodiment, the orifice 31 as the second guide passage 14 is formed at the middle part of the second wall section 22 of the crucible 4, whereas in the present embodiment, the orifice 31 is formed at a boundary position between the second wall section 22 and the third wall section 23 so as to penetrate the second wall section 22. Forming the second guide passage 14 at such a position allows the vaporized material to be sent via the third wall section 23 to the second guide passage 14 above.

The other aspects of the present embodiment are the same as those of the first embodiment, and operations and effects similar to those of the first embodiment are exerted in the present embodiment as well.

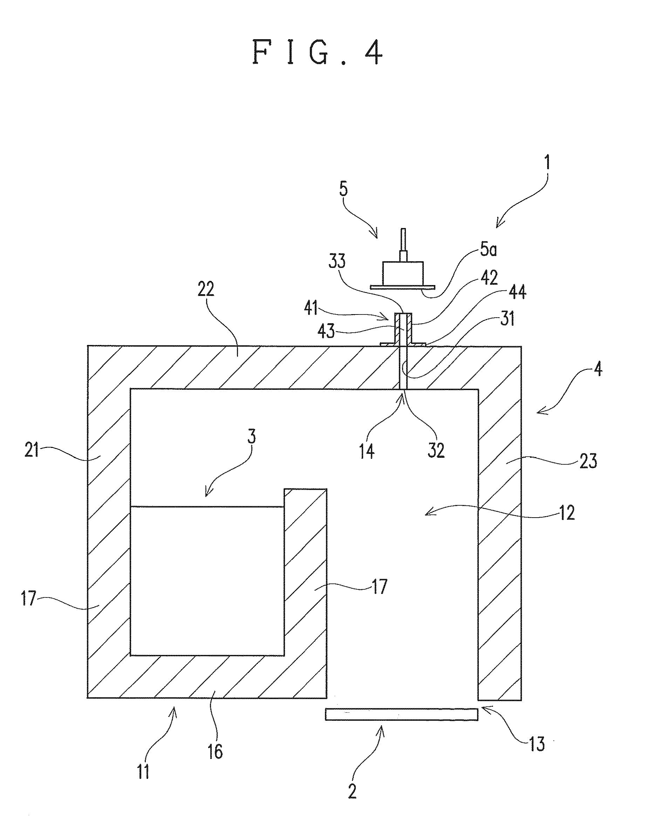

FIG. 4 illustrates a fourth embodiment of the vapor deposition apparatus 1, the crucible 4 and the vapor deposition method according to the present invention. In the present embodiment, the structure of the second guide passage 14 is different from that of the first embodiment. More specifically, in the present embodiment, a protrusion 41 that protrudes outward is formed on an outer surface of the second wall section 22 of the crucible 4. Furthermore, the second guide passage 14 is formed so as to penetrate this protrusion 41.

In the present embodiment, a cylindrical member 42 is used as the protrusion 41. This cylindrical member 42 includes an orifice 43 that penetrates along its cylinder center direction. The diameter of this orifice 43 is constant throughout the overall length in the cylinder center direction of the cylindrical member 42. Therefore, the diameter at one end in the length direction is equal to the diameter at the other end of this cylindrical member 42. Moreover, the cylindrical member 42 includes a flange 44 at the one end in its cylinder center direction. The diameter of the orifice 31 formed in the second wall section 22 of the crucible 4 is substantially equal to the diameter of the orifice 43 of the cylindrical member 42.

The cylindrical member 42 is configured integrally with the second wall section 22 by fixing the flange 44 at a predetermined position on the outer surface of the second wall section 22. In this case, the cylindrical member 42 is fixed to the second wall section 22 so that the orifice 31 formed in the second wall section 22 coincides with the orifice 43 of the cylindrical member 42. This causes the orifice 31 of the second wall section 22 to communicate with the orifice 43 of the cylindrical member 42. In this configuration, in the second guide passage 14 of the present embodiment, the inside opening of the orifice 31 formed in the second wall section 22 constitutes the inlet 32 for the vaporized material. Moreover, the opening outside the cylindrical member 42 constitutes the outlet 33 for the vaporized material.

With the above-described configuration, in the present embodiment, the protrusion 41 (cylindrical member 42) allows the second guide passage 14 to extend out of the crucible 4. That is, the crucible 4 allows the length of the second guide passage 14 to be greater compared to the first embodiment. Compared to the first embodiment, the present embodiment can increase the spacing between the sensor and the crucible. This provides particularly effective measures, for example, for when the measuring accuracy deteriorates under influences of radiant heat from the crucible.

The other aspects of the present embodiment are the same as those of the first embodiment, and operations and effects similar to those of the first embodiment are exerted in the present embodiment as well.

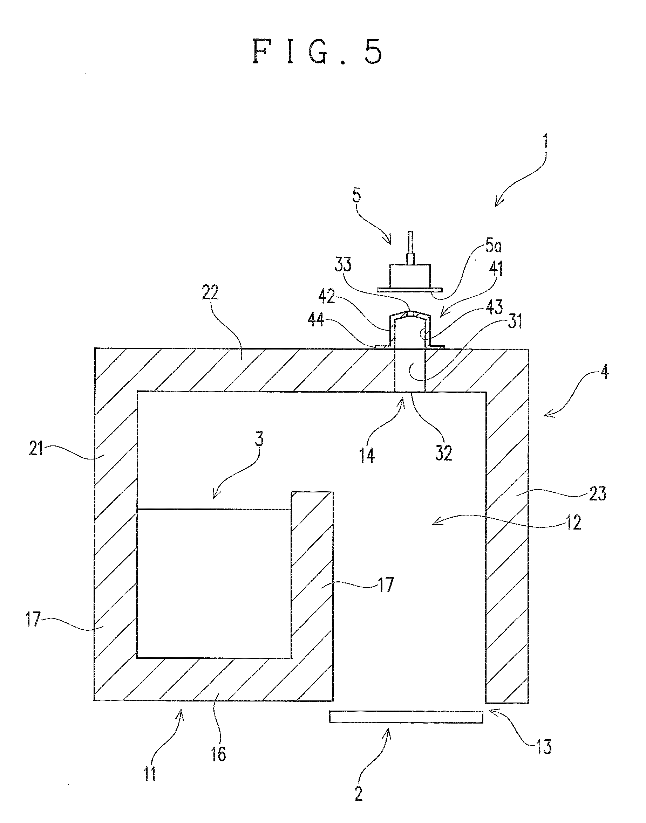

FIG. 5 illustrates a fifth embodiment of the vapor deposition apparatus 1, the crucible 4 and the vapor deposition method according to the present invention. The present embodiment is different from the fourth embodiment in the configuration of the second guide passage 14. More specifically, the present embodiment as well as the fourth embodiment adopts the cylindrical member 42 as the protrusion 41, and this cylindrical member 42 is configured so that the diameter at one end thereof in the cylinder center direction is different from the diameter at the other end thereof. More specifically, in this cylindrical member 42, the diameter at one end on the side on which the flange 44 is formed is larger and the diameter at the other end on the side opposite to the sensor 5 is smaller. The diameter of the orifice 31 formed in the second wall section 22 is substantially equal to the diameter at the one end of the cylindrical member 42.

According to this configuration, in the second guide passage 14 of the present embodiment, the diameter of the inlet 32 of the vaporized material is larger and the diameter of the outlet 33 is smaller. Therefore, in the present embodiment, more vaporized material can be introduced from the inlet 32 of the second guide passage 14 and the vaporized material with a higher density can be emitted toward the sensor 5 from the outlet 33 formed to be smaller than the inlet 32.

The other aspects of the present embodiment are the same as those of the fourth embodiment, and operations and effects similar to those of the fourth embodiment are exerted in the present embodiment as well.

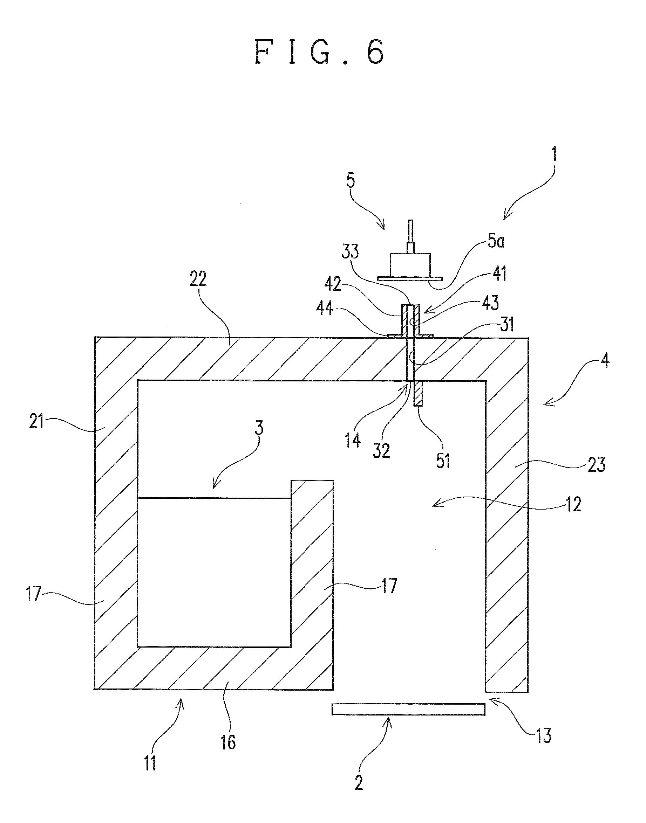

FIG. 6 illustrates a sixth embodiment of the vapor deposition apparatus 1, the crucible 4 and the vapor deposition method according to the present invention. The present embodiment is different from the fourth embodiment in that a protrusion 51 that protrudes inside the crucible 4 is formed on an inner surface side of the second wall section 22 so as to guide the vaporized material that passes through the first guide passage 12 to the second guide passage 14. This protrusion 51 is fixed to the inner surface of the second wall section 22 at a position between the inlet 32 of the second guide passage 14 formed in the second wall section 22 and the third wall section 23. Furthermore, this protrusion 51 is formed into a planar shape, for example, and provided at a position proximate to the inlet 32 of the second guide passage 14.

As shown above, with the planar protrusion 51 formed at the predetermined position on the inner surface of the second wall section 22, the vaporized material that passes through the first guide passage 12 can be guided to the second guide passage 14 via this protrusion 51.

The other aspects of the present embodiment are the same as those of the fourth embodiment, and operations and effects similar to those of the fourth embodiment are exerted in the present embodiment as well.

The crucible, the vapor deposition apparatus and the vapor deposition method according to the present invention are not limited to the configurations of the above-described embodiments. The crucible, vapor deposition apparatus and vapor deposition method according to the present invention are not limited to the above-described operations and effects, either. The crucible, the vapor deposition apparatus and the vapor deposition method according to the present invention can be modified in various ways without departing from the spirit and scope of the present invention.

For example, although an example has been described in the above-described embodiments, where the second guide passage 14 is formed in the second wall section 22 of the crucible 4, the second guide passage 14 may also be formed in the first, and third to fifth wall sections other than the second wall section 22.

Although an example has been described in the fourth to sixth embodiments, where the cylindrical member 42 is used as the protrusion, without being limited to this, a polygonal, oval or modified cylindrical member may also be used. Moreover, radiating fins may also be provided on the outer surface of this protrusion so as to improve cooling performance of the vaporized material in this protrusion.

Furthermore, instead of the cylindrical member, the protrusion 41 may be formed by increasing the thickness of part of the second wall section 22 compared to the rest of the second wall section 22, and the orifice 31 may be formed so as to penetrate this protrusion 41 to thereby configure the second guide passage 14.

In addition, a plurality of second guide passages 14 may be formed in the crucible 4. In this case, a closing member may be provided which closes each inlet 32 or each outlet 33 of the second guide passages 14 in an openable/closable manner and the respective second guide passages 14 may be used as required.

### REFERENCE SIGNS LIST

- 1: Vapor deposition apparatus
- 2: Substrate to be treated
- 3: Vapor deposition source
- 4: Crucible
- 5: Sensor
- 5a: Detection surface
- 11: Storage section
- 12: First guide passage
- 13: Emission port
- 14: Second guide passage
- 16: Bottom wall section
- 17: Side wall section
- 21: First wall section
- 22: Second wall section
- 23: Third wall section
- 31: Orifice
- 32: Inlet
- 33: Outlet
- 41: Protrusion
- 42: Cylindrical member
- 43: Orifice
- 44: Flange section
- 51: Protrusion
- 101: Vapor deposition source
- 102: Storage section
- 103: Substrate to be treated
- 104: Guide passage
- 105: Crucible

## Claims

1. A crucible for vapor deposition comprising:
a storage section that stores a vapor deposition source;
a first guide passage that guides a vaporized material emitted from the vapor deposition source toward a substrate to be treated;
a wall section for defining the first guide passage; and
a second guide passage that diverges from a middle part of the first guide passage, penetrates the wall section and communicates with the outside.

2. The crucible for vapor deposition according to claim 1, wherein the second guide passage is an orifice that penetrates the wall section.

3. The crucible for vapor deposition according to claim 2, wherein a protrusion that protrudes outward is provided on an outer surface of the wall section and the second guide passage is formed so as to penetrate the protrusion and communicate with the orifice of the wall section.

4. A vapor deposition apparatus comprising:
the crucible for vapor deposition according to any one of claims 1 to 3;
a vacuum chamber that can store the crucible for vapor deposition therein;
a vacuum pump connected to the vacuum chamber;
a heater for heating the crucible for vapor deposition; and
a sensor for measuring a thickness of a film formed by a vaporized material from a vapor deposition source adhering to a substrate to be treated.

5. A vapor deposition method for causing a vaporized material emitted from a vapor deposition source to be vapor-deposited on a substrate to be treated by the vapor deposition apparatus according to claim 4, the method comprising:
detecting the vaporized material emitted from the second guide passage by the sensor provided in the vacuum chamber; and
causing the vaporized material to be vapor-deposited on the substrate to be treated while measuring a thickness of a film formed by the vaporized material adhering to the substrate to be treated.
